# EUROPEAN PATENT SPECIFICATION

(11) **EP 4 618 161 B1**
(45) Date of publication and mention of the grant of the patent: **09.09.2026**
(21) Application number: 24305366.7
(22) Date of filing: 11.03.2024
(51) Int. Cl.: H01G 4/33, H01G 4/12, H01G 4/10, H10D 1/68, H10D 1/66

(54) **ELECTRICAL DEVICE COMPRISING A CAPACITOR WITH AN IMPROVED DIELECTRIC STRUCTURE**
ELEKTRISCHE VORRICHTUNG MIT EINEM KONDENSATOR MIT VERBESSERTER DIELEKTRISCHER STRUKTUR
DISPOSITIF ÉLECTRIQUE COMPRENANT UN CONDENSATEUR À STRUCTURE DIÉLECTRIQUE AMÉLIORÉE

(43) Date of publication of application: 17.09.2025
(73) Proprietor: Murata Manufacturing Co., Ltd., Nagaokakyo-shi, Kyoto 617-8555 (JP)
(72) Inventor: BUFFLE, Larry, 38000 GRENOBLE (FR); SALLAZ, Valentin, 38000 GRENOBLE (FR); VOIRON, Frédéric, 38530 BARRAUX (FR)
(74) Representative: Cabinet Beau de Loménie

(56) References cited:
- EP-B1- 1 090 423
- US-A- 4 990 463
- US-A1- 2016 190 230
- US-A1- 2021 257 502
- BOETTCHER N ET AL: "Silicon RC-Snubber for 900 V Applications Utilising non-Stoichiometric Silicon Nitride", 2019 31ST INTERNATIONAL SYMPOSIUM ON POWER SEMICONDUCTOR DEVICES AND ICS (ISPSD), IEEE, 19 May 2019 (2019-05-19), pages 351 - 354, XP033574593, ISBN: 978-1-7281-0580-2, [retrieved on 20190708], DOI: 10.1109/ISPSD.2019.8757589

## Description

### Field of the invention

The present invention relates to the field of electrical devices. More particularly, it relates to an electrical device comprising a capacitor and a method for manufacturing thereof. The present invention is particularly advantageous for implementing capacitors for high voltage applications, but such an application is only given as an illustrative example and does not limit the invention.

### Description of Related Art

The present invention lies within the particular context of three-dimensional (3D) capacitors for high voltage applications, but is not limited to this particular context.

Capacitors with 3D capacitive structures have been developed in view of providing high energy storage density. Typically, such 3D capacitive structures are formed conformally on reliefs (e.g., pores, holes, trenches, or pillars) and provide a large specific area for a given component size. Still, capacitors with 3D structures cannot be directly transposed to high voltage applications (e.g., exceeding 900 V, or 1,200 V) without considering the specific features and constraints of these applications.

In particular to withstand high voltages, 3D capacitive structures with significantly thicker dielectric structures are used (e.g., dielectric structures thicker than 500 nm, or even 1,000 nm). It is also known to use multi-layer dielectric structures for high voltage applications. This allows adjusting the properties of the dielectric structure including its dielectric strength, mechanical stress, and adherence to the capacitor electrodes. Thick and multi-layer dielectric structures are used to achieve high dielectric strength in order to increase the breakdown voltage and ensure reliable operation at high voltages.

However, the use of particularly thick dielectric structures induces significant mechanical stress within the capacitive structure. This mechanical stress can result in cracks in the dielectric structure and hence a deterioration of its electrical properties, including a reduction in its dielectric strength and an increase in leakage current. This negatively impacts the breakdown voltage and reliability of the capacitor.

From the prior art, documents US 2021/257502 A1 and US 2016/190230 A1 disclose known capacitor structures.

Therefore, there is a need for an electrical device comprising a capacitor with an improved dielectric structure capable of reliably withstanding high voltages.

### Summary of the invention

The present invention has been made in light of the above problems. The present invention provides an electrical device comprising a capacitor, the electrical device defined by independent claim 1, and a method for manufacturing an electrical device comprising a capacitor, the method defined by independent claim 8. Further embodiments are defined in the dependent claims.

The present invention provides an electrical device defined by independent claim 1. In particular, the proposed electrical device comprises a capacitor including: a cathode capacitor electrode, an anode capacitor electrode, and a dielectric structure interposed between the cathode capacitor electrode and the anode capacitor electrode,
wherein the dielectric structure comprises a stack of dielectric layers including: a dielectric layer in contact with the cathode capacitor electrode, and two or more other dielectric layers, and
wherein a product of a dielectric strength and a permittivity of the dielectric layer in contact with the cathode capacitor electrode is greater than a product of a dielectric strength and a permittivity of each of said two or more other dielectric layers.

The present invention relates to an electrical device comprising a capacitor which includes a cathode and an anode. The capacitor is intended to be used according to a specific polarity in which the cathode is the negatively charged electrode of the capacitor and the anode is the positively charged electrode of the capacitor. When the capacitor is used according to the proper polarity (cathode negatively charged and anode positively charged), the electrical performance of the capacitor is enhanced (compared with the use of the capacitor according to the improper polarity), and in particular its breakdown voltage.

Hereinafter, the expression *"dielectric strength of a dielectric layer"* (also known as dielectric rigidity) is used to refer to the maximum electrical field *E*_{crit} that the dielectric layer can withstand without undergoing electrical breakdown. The expression *"permittivity of a dielectric layer"* is also used to refer to either the relative permittivity *εᵣ* of the dielectric layer or the absolute permittivity. In the present disclosure, the relative permittivity *εᵣ* is used for the sake of convenience, but the person skilled in the art will be able to substitute relative permittivity values with absolute permittivity values if needed.

The present invention proposes using a multilayer dielectric structure (said stack of dielectric layers that are stacked in the direction anode-cathode) wherein the dielectric layer with the highest figure of merit *E*_{crit} × *εᵣ* is placed in contact with the cathode. This allows significantly improving the dielectric performance of the dielectric structure for the following reasons (these reasons are further detailed below in reference to the figures).

First, we consider a single dielectric layer. For a single layer, the Selbeherr's model links the effective breakdown of the layer to: (a) the leakage current *(i.e.,* the current density |*̅J̅ₙ̅*̅|) driven by the electrical field *E*_{field} applied to the layer, and (b) the dielectric strength *E*_{crit} of the layer. From the Selberherr's model, it follows that a dielectric layer achieves a higher breakdown when the ratio *E*_{crit}/*E*_{field} is increased for this dielectric layer.

Second, we consider a dielectric structure with a stack of multiple dielectric layers. With such dielectric structure, it can be shown that the dielectric layer with the highest ratio *E*_{crit}/ *E*_{field} is the dielectric layer with the highest figure of merit *E*_{crit} × *εᵣ*. In other words, the dielectric layer with the highest figure of merit *E*_{crit} × *εᵣ* is the strongest layer of the dielectric structure *(i.e.,* the layer with the highest breakdown voltage).

Third, in a polarized capacitor, the cathode appears to be the critical electrode. The direction of the electric field promotes injection of electrons on the cathode side (electrons move towards higher potential). For this reason, placing the strongest dielectric layer of the dielectric structure in front of the cathode allows reducing the electron free circulation.

It follows from the above that placing the dielectric layer with the highest figure of merit *E*_{crit} × *εᵣ* in contact with the cathode allows improving the dielectric properties of the dielectric structure. Specifically, it allows reducing the leakage current in the dielectric structure and increases the dielectric strength thereof. This has been confirmed by the inventors' experimental results (which are detailed hereinafter). A higher breakdown voltage and improved reliability of the capacitor follow as a result.

For these reasons, the present invention provides an electrical device comprising a capacitor with an improved dielectric structure capable of reliably withstanding high voltages.

In the claimed invention, at least one of said two or more other layers of the dielectric structure (*i.e.,* a dielectric layer of the dielectric structure not in contact with the cathode) comprises non-stoichiometric silicon-rich silicon nitride.

The claimed invention proposes forming the dielectric structure using non-stoichiometric silicon-rich silicon nitride. This material is also referred to as *"lower-stress silicon nitride"* and noted SiₓN_{y} with x/y>3/4. The use of silicon-rich silicon nitride allows providing a dielectric structure with limited intrinsic mechanical stress. This embodiment is therefore advantageous in that it limits mechanical stress within the capacitive structure, and any negative consequences associated with such stress.

In the claimed invention, the dielectric layer in contact with the cathode capacitor electrode comprises stoichiometric silicon nitride (Si₃N₄),
at least one of said two or more other dielectric layers includes a layer (*i.e.,* a layer of the dielectric structure not in contact with the cathode) comprising non-stoichiometric silicon-rich silicon nitride (SiₓN_{y} with x/y>3/4), and
at least one of said two or more other dielectric layers includes a layer (*i.e.,* another layer of the dielectric structure not in contact with the cathode) comprising silicon oxide (SiO₂).

The claimed invention is advantageous in that it provides a dielectric structure with a strong adherence to the anode and a limited intrinsic mechanical stress. The use of (thermally grown) silicon oxide SiO₂ allows a strong adherence to the anode *(e.g.,* a silicon substrate comprising protruding walls). And, the use of non-stoichiometric silicon-rich silicon nitride SiₓN_{y} (with x/y>3/4) allows limiting the mechanical stress within the dielectric structure.

The claimed invention is also advantageous in that it provides a dielectric structure with a strong dielectric strength and a reduced leakage current. This results from the stacking order of the different layers within the dielectric structure. The dielectric layer comprising stoichiometric silicon nitride (Si₃N₄) is the dielectric layer with the highest figure of merit *E*_{crit} × *εᵣ* and is placed in contact with the cathode.

In the claimed invention, a thickness of the dielectric layer comprising stoichiometric silicon nitride (Si₃N₄) is comprised between 20 nm and 200 nm, a thickness of the dielectric layer comprising non-stoichiometric silicon-rich silicon nitride (SiₓN_{y} with x/y>3/4) is comprised between 500nm and 1500nm, and a thickness of the dielectric layer comprising silicon oxide (SiO₂) is comprised between 100 nm and 1000 nm.

The inventors have observed that the dielectric structure provided according to the claimed invention is particularly advantageous. The materials and thicknesses used for the various dielectric layers allow providing a dielectric structure with a strong adherence to the anode, a limited intrinsic mechanical stress, and a high breakdown voltage.

In a particular embodiment, an intrinsic mechanical stress of the layer comprising non-stoichiometric silicon-rich silicon nitride (SiₓN_{y} with x/y>3/4) is comprised between 300 MPa and 600 MPa.

According to this embodiment, lower-stress silicon nitride SiₓN_{y} (with x/y>3/4) is used to form the dielectric structure of the capacitor. This allows providing a thick dielectric structure while limiting its intrinsic mechanical stress. In other words, it allows providing a thick dielectric structure while avoiding a deterioration of its electrical properties of the dielectric structure resulting from mechanical stress within the structure. This embodiment is thus advantageous in that it provides a capacitor with a dielectric structure suited for high-voltages applications.

In a particular embodiment, the cathode capacitor electrode comprises (or is formed by) a metal layer, a degenerate semiconductor layer, or a trap-rich layer *(e.g.,* a polysilicon layer).

According to this embodiment, the cathode is made of metals, degenerate semiconductor, or a trap-rich layer (such as a polysilicon layer). In other words, the cathode behaves as a metal. This allows eliminating the non-linear effects associated with semiconductors. In particular, this prevents depletion mechanisms from occurring if the capacitor is used in reverse polarity (*i.e.,* according to the improper polarity).

In a particular embodiment, the anode capacitor electrode or the cathode capacitor electrode comprises a conductive structure having reliefs, such as pores, holes, trenches, or pillars.

This embodiment proposes using a three-dimensional capacitor. That is, a capacitor whose capacitive structure is formed conformally on reliefs such as pores, holes, trenches, or pillars. The use of a three-dimensional capacitor allows providing a large specific area for a given component size. A high capacitance density follows as a result.

According to an example, the anode (or respectively the cathode) comprises a conductive structure formed using a semiconductor substrate with trenches. The dielectric structure extends conformally on the conductive structure, and the cathode (or respectively the anode) extends conformally on the dielectric structure. The use of a semiconductor substrate allows using thick dielectric layers *(e.g.,* by using wide trenches). This provides a capacitor with a high energy storage density and high breakdown voltage, which is particularly suited for high-voltage applications.

According to another example, the anode (or respectively the cathode) comprises a conductive structure formed using an anodic aluminum oxide (AAO) substrate with pores covered by a conductive layer. The dielectric structure extends conformally on the conductive structure, and the cathode (or respectively the anode) extends conformally on the dielectric structure. The use of an AAO substrate with pores allows achieving a high capacitance density. This provides a capacitor with a high energy storage density, which is suited for low-voltage applications.

In a particular embodiment, the electrical device is configured to be used with an operating voltage measured between the anode capacitor electrode and the cathode capacitor electrode exceeding 900 V or 1,200 V, and preferably with an operating voltage comprised between 1,200 V and 1,500 V.

For instance, the proposed electrical device may be used as a decoupling or snubber capacitive element for power electronic.

In another particular embodiment, the electrical device is configured to be used with an operating voltage measured between the anode capacitor electrode and the cathode capacitor electrode comprised between 0.65 V and 10 V.

According to another aspect, the present invention also provides an electronic circuit comprising a voltage supply and the proposed electrical device, wherein the anode capacitor electrode of the electrical device is connected to a positive output of the voltage supply and the cathode capacitor electrode of the electrical device is connected to a negative output of the voltage supply.

The present invention provides a method for manufacturing an electrical device comprising a capacitor, the method defined by independent claim 8. In particular, the proposed manufacturing method comprises:
forming a capacitor of the electrical device including: a cathode capacitor electrode, an anode capacitor electrode, and a dielectric structure interposed between the cathode capacitor electrode and the anode capacitor electrode,
wherein the dielectric structure comprises a stack of dielectric layers including: a dielectric layer in contact with the cathode capacitor electrode, and two or more other dielectric layers, and
wherein a product of a dielectric strength and a permittivity of the dielectric layer in contact with the cathode capacitor electrode is greater than a product of a dielectric strength and a permittivity of each of said two or more other dielectric layers.

The proposed manufacturing method can be adapted to obtain any one of the electrical devices defined in the present disclosure. Further, it should be noted that the embodiments of the proposed method for manufacturing an electrical device present the advantages described in relation with the embodiments of the proposed electrical device.

In a particular embodiment, the proposed method comprises a preliminary step of selecting the dielectric layer in contact with the cathode capacitor electrode such that:
the product of the dielectric strength and the permittivity of the dielectric layer in contact with the cathode capacitor electrode is greater than the product of the dielectric strength and the permittivity of each of said one or more other dielectric layers.

In a particular embodiment, the proposed method comprises for each dielectric layer of the dielectric structure:
obtaining (determining, evaluating, or computing) the product of the dielectric strength and the permittivity of the dielectric layer.

In a particular embodiment, the product of the dielectric strength and the permittivity of each dielectric layer is obtained based on:
a property of a material comprised in this dielectric layer *(e.g.,* a composition of the material, a type of material such as crystalline or polycrystalline), and
a thickness of this dielectric layer, and
preferably also on a deposition technique used (or intended to be used) for this dielectric layer.

### Brief Description of the Drawings

Further features and advantages of the present invention will become apparent from the following description of certain embodiments thereof, given by way of illustration only, not limitation, with reference to the accompanying drawings in which:
FIG. 1 and 2 illustrate cross-section views of an electrical device according to embodiments of the invention; and
FIG. 3 and 4 illustrate experimental results related to the invention.

### Detailed Description of Example Embodiments

The present invention provides an electrical device comprising a capacitor with an improved dielectric structure. More specifically, embodiments of the present invention seek to improve the dielectric performance of a multi-layer dielectric structure, in particular by reducing leakage current and increasing the dielectric strength of the dielectric structure.

The present invention lies within the particular context of 3D capacitors for high voltage applications. The following description of the invention will refer to this particular context, which is only given as an illustrative example and should not limit the invention. The invention can also be used for applications other than high-voltage applications, and for capacitors other than 3D capacitors.

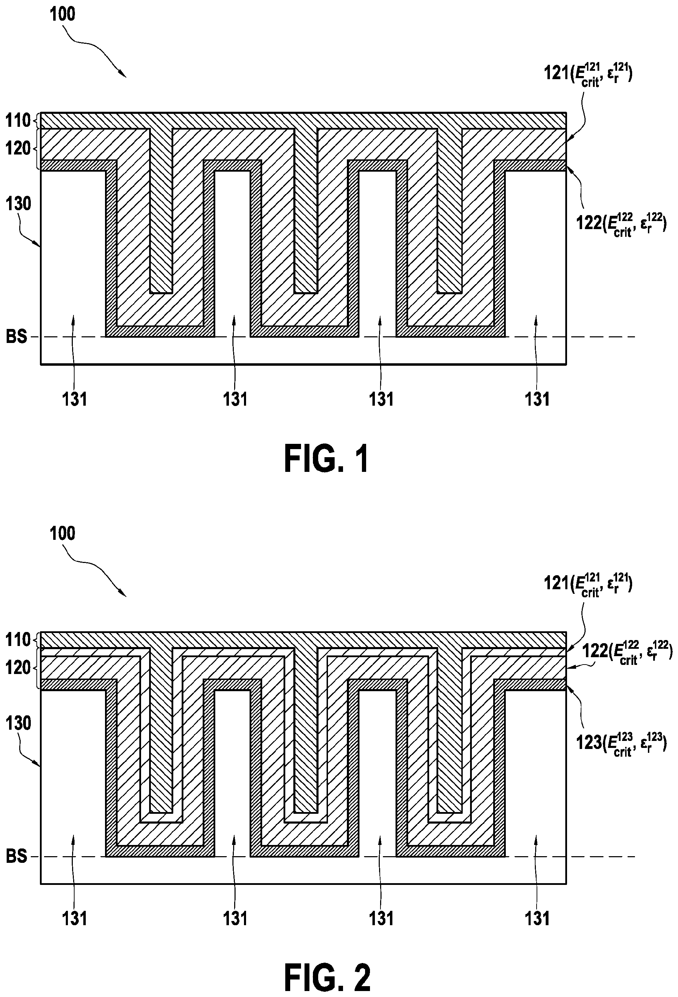

**FIG. 1** illustrates a cross-section of an electrical device according to an embodiment of the invention. This figure is described hereinafter to introduce the present invention.

The electrical device 100 comprises a polarized capacitor formed by a cathode capacitor electrode 110 (here, the top electrode) and an anode capacitor electrode 130 (here, the bottom electrode) separated by a dielectric structure 120.

The bottom electrode 130 comprises a conductive structure with reliefs. Here, the reliefs of the conductive structure are formed by facing walls 131 extending upwards from a base surface BS of the conductive structure.

The conductive structure can be formed by etching a semiconductor substrate (e.g., a doped silicon substrate). The conductive structure could also be formed by a 3D substrate *(e.g.,* an anodic aluminum oxide substrate comprising pores) covered by a conductive layer.

The walls 131 may present: a (substantially) linear shape, or a curved shape, or (substantially) linear shapes joined together by corners. In a particular embodiment, the walls 131 form one or more trenches, for instance, a plurality of separate adjacent trenches or a trench extending in a meander-shape.

The dielectric structure 120 extends conformally over the walls 131 of the bottom electrode 130. It comprises a stack of multiple dielectric layers 121-122 (stacked on each other along the bottom electrode 130 to top electrode 110 direction, the anode-cathode direction).

The top electrode 110 comprises at least one conductive layer *(e.g.,* a layer of polysilicon) extending conformally on the dielectric structure 120.

The top electrode 110 fills the recesses (e.g., the trenches) formed by the walls 131. In other words, the top surface of the top electrode 110 lies above the top surface of the dielectric structure 120 and above the top surface of the walls 131.

This figure illustrates a polarized capacitor in which the top electrode is the cathode 110 and the bottom electrode is the anode 130. However, other embodiments of the invention could be envisaged in which the bottom electrode is the cathode and the top electrode is the anode.

Embodiments of the invention also relates to an electronic circuit comprising a voltage supply and the proposed electrical device 100, wherein the anode 130 of the electrical device 100 is connected to a positive output of the voltage supply and the cathode 130 of the electrical device 100 is connected to a negative output of the voltage supply.

For instance, the proposed electrical device 100 may be used as a decoupling or snubber capacitive element for power electronic, wherein the operating voltage exceeds 900 V or 1,200 V, and is preferably between 1,200 V and 1,500 V.

For such applications, the capacitor of the electronic device 100 has to be able to reliably withstand high voltages. It is therefore required to have a high breakdown voltage and a high reliability. Meeting these requirements relies in particular on the dielectric properties of the dielectric structure 120 used in the capacitor.

This raises the question of how to select and place the various layers of dielectric structure 120 to improve its dielectric properties and meet these requirements. To answer this question, the inventors have made the developments and observations presented below - points (1) to (4) - which support the present invention:

### (1) Single dielectric layer: electrical field, leakage current, and breakdown

We first consider a single dielectric layer. For a single layer, the Selbeherr's model links the effective breakdown of a single layer to: (a) the leakage current *(i.e.,* the current density |*̅J̅ₙ̅*̅| in the equation below) driven by the electrical field *E*_{field} applied to the layer, and (b) the dielectric strength *E*_{crit} of the layer.

Further details on this model can be found in S. Selberherr, "On modeling MOS-devices", Process and device modeling, North-Holland Publishing Co., NLD, 265-299, 1986, and in W. Maes, et al., "Impact ionization in silicon: A review and update", in Solid-State Electronics, vol. 33, no. 6, pp. 705-718, 1990.

The Selberherr's model characterizes the avalanche in case of breakdown. In this model, the avalanche generation term for electrons is expressed as follows: ${G}_{n}^{II} = {α}_{n} ⋅ \frac{\left|\vec{{J}_{n}}\right|}{q} ,$
where |*̅J̅ₙ̅*̅| is the current density, q is the elementary charge, and *αₙ* is the ionization rate for electrons. The latter is defined by the following expression: ${α}_{n} = {α}_{n}^{∞} \left(T\right) ⋅ exp \left(-{\left(\frac{{E}_{crit}}{{E}_{field}}\right)}^{{γ}_{n}}\right) .$

In this equation, the coefficients ${α}_{n}^{∞}$, T (temperature), and the exponent *γₙ* are positive real numbers. Here, *E*_{crit} is the threshold electrical field to activate ionization mechanisms. It varies depending on the material composition and its microstructure. And, *E*_{field} is the effective electrical field component seen by the charges flowing in the dielectric, expressed by *E*_{field} = *̅E̅ₙ̅*̅·*̅J̅ₙ̅*̅/|*̅J̅ₙ̅*̅|.

From the above equations, we see that a higher *E*_{crit}/*E*_{field} ratio results in a lower ionization rate *αₙ* and hence a lower avalanche generation term ${G}_{n}^{II}$.

Therefore, considering a single dielectric layer, it follows that the dielectric layer achieves a higher breakdown field when the ratio *E*_{crit}/*E*_{field} is increased for this dielectric layer.

### (2) Multilayer dielectric structure: electrical field division between the dielectric layers

We now consider a dielectric structure comprising a stack of multiple layers, and study the electrical field division between the different layers of the dielectric structure.

To this end, we use an example wherein the dielectric structure comprises a SiO₂ layer and a Si₃N₄ layer.

Setting the electrical field value in the SiO₂ layer to ${E}_{field}^{SiO 2} = 10 MV / cm$, we evaluate the electrical field value in the Si₃N₄ layer. We use the dielectric constant ratio ${E}_{field}^{SiO 2} / {E}_{field}^{Si 3 N 4} = {ε}_{r}^{Si 3 N 4} / {ε}_{r}^{SiO 2}$ . Table 1 in annex outlines the values of *εᵣ* for thin dielectric layers of SiO₂ and Si₃N₄ (and also for thin dielectric layers of other materials). Based on the values in Table 1, we have ${ε}_{r}^{Si 3 N 4} / {ε}_{r}^{SiO 2} = 1.92$. We finally obtain ${E}_{field}^{Si 3 N 4} ≃ 5.2 MV / cm$.

We can now determine the *E*_{crit}/*E*_{field} ratio for each layer in the dielectric structure. Using the values of Table 1, we have ${E}_{crit}^{SiO 2} / {E}_{field}^{SiO 2} = 15 / 10 and {E}_{crit}^{Si 3 N 4} / {E}_{field}^{Si 3 N 4} = 7 / 5.2$.

We thus have ${E}_{crit}^{SiO 2} / {E}_{field}^{SiO 2} > {E}_{crit}^{Si 3 N 4} / {E}_{field}^{Si 3 N 4}$. In other words, the margin between ${E}_{field}^{SiO 2}$ and ${E}_{crit}^{SiO 2}$ is greater than the margin between ${E}_{field}^{Si 3 N 4}$ and ${E}_{crit}^{Si 3 N 4}$. The Si3N4 layer will hence wear out faster than the SiO2 layer. This impacts negatively the reliability and/or the breakdown voltage of the considered bilayer dielectric structure, and thus the reliability and/or the performances of the capacitor.

In fact, for most multilayer dielectric structures, the dielectric strength ratio is not matched with the dielectric constant ratio. Hence, one of the dielectric layers of the dielectric structure wears out faster than the other layers. This negatively impacts the reliability of capacitor.

It can be analytically shown that ${E}_{crit}^{SiO 2} \times {ε}_{r}^{SiO 2} > {E}_{crit}^{Si 3 N 4} \times {ε}_{r}^{Si 3 N 4}$ leads to ${E}_{crit}^{SiO 2} / {E}_{field}^{SiO 2} > {E}_{crit}^{Si 3 N 4} / {E}_{field}^{Si 3 N 4}$ using the dielectric constant ratio ${E}_{field}^{SiO 2} / {E}_{field}^{Si 3 N 4} = {ε}_{r}^{Si 3 N 4} / {ε}_{r}^{SiO 2}$. It means that the SiO2 layer has the highest figure of merit ${E}_{crit}^{SiO 2} \times {ε}_{r}^{SiO 2}$ and therefore the highest ratio ${E}_{crit}^{SiO 2} / {E}_{field}^{SiO 2}$. This result is not limited to this particular example, and applies to any material (and/or its deposition method) and any number of layers in the dielectric structure.

Therefore, considering a multilayer dielectric structure, the dielectric layer with the highest figure of merit *E*_{crit} × *εᵣ* is also the dielectric layer with the highest ratio *E*_{crit}/*E*_{field}.

By combining this result with the conclusion of point (1), it follows that the dielectric layer with the highest figure of merit *E*_{crit} × *εᵣ* is the layer of the dielectric structure with the highest breakdown.

We can then conclude that the dielectric layer with the highest figure of merit *E*_{crit} × *εᵣ* is the strongest dielectric layer of the multi-layer dielectric structure.

### (3) Polarized capacitor: the critical electrode

Following the above points, the next step is to determine where to place the strongest dielectric layer in the dielectric structure to improve the dielectric properties of this structure.

In a polarized capacitor, the cathode appears to be the critical electrode (this is confirmed by the inventor's experimental results detailed below). The direction of the electric field promotes injection of electrons on the cathode side (electrons move towards higher potential). For this reason, the strongest dielectric layer of the dielectric structure is to be placed in front of the cathode to reduce the electron free circulation.

### (4) The proposed solution: placing the dielectric layer with the highest figure of merit E_{crit} × εᵣ in contact with the cathode

It follows from the above points (1) to (3) that placing the dielectric layer with the highest figure of merit *E*_{crit} × *εᵣ* in contact with the cathode allows improving the dielectric properties of the dielectric structure. Specifically, it allows reducing the leakage current in the dielectric structure and increases the dielectric strength thereof. This has been confirmed by the inventors' experimental results (which are detailed hereinafter). A higher breakdown voltage and improved reliability of the capacitor follow as a result.

The principles of the present invention have been outlined above. We now illustrate these principles by describing the example embodiment of the following figure.

**FIG. 2** illustrates a cross-section view of an electrical device according to an embodiment of the invention.

In contrast to FIG. 1, the electrical device 100 of FIG. 2 comprises a dielectric structure 120 with a stack of three dielectric layers 121, 122, 123 (stacked on each other).

The first dielectric layer 121 in contact with the top electrode 110 (here, the cathode) comprises stoichiometric silicon nitride (Si₃N₄). The thickness of this layer 121 is comprised between 20 nm and 200 nm.

The second dielectric layer 122 comprises non-stoichiometric silicon-rich silicon nitride (SiₓN_{y} with x/y > 3/4). The thickness of this layer is comprised between 500 nm and 1500 nm. The mechanical stress of the second dielectric layer 122 is comprised between 300 MPa and 600 MPa. The use of this silicon-rich silicon nitride layer 122 (also referred to as lower-stress silicon nitride) allows providing a dielectric structure 120 with limited intrinsic mechanical stress.

The third dielectric layer 123 extends conformally over (in contact) with the bottom electrode 130 (here, the anode), and comprises silicon oxide (SiO₂). The thickness of this layer is comprised between 100 nm and 1000 nm. This dielectric layer 123 can be formed using thermal oxidation of the conductive structure 110 *(e.g.,* a silicon substrate). The use of this silicon oxide layer 123 allows achieving strong adherence to the bottom electrode 130.

This embodiment is particularly advantageous in that it provides a dielectric structure 120 with a strong adherence to the bottom electrode 130 (comprising the walls 131) and a limited intrinsic mechanical stress.

It should also be emphasized that this embodiment further provides a dielectric structure 120 with a strong dielectric strength and a reduced leakage current. This results from the stacking order of the different dielectric layers 121-123 within the dielectric structure 120.

Following the principles detailed above, the stacking order of the dielectric layers 121-123 is such that: the dielectric layer 121 in contact with the cathode 110 has the highest figure of merit *E*_{crit} × *εᵣ* of all the layers in the dielectric structure 120 (*i.e.,* ${E}_{crit}^{121} \times {ε}_{r}^{121} > {E}_{crit}^{122} \times {ε}_{r}^{122}$ and ${E}_{crit}^{121} \times {ε}_{r}^{121} > {E}_{crit}^{123} \times {ε}_{r}^{123}$).

Table 2 in annex presents the values of *E*_{crit} × *εᵣ* for thick dielectric layers of different materials. Specifically, using the values in this table, we have: ${E}_{crit}^{Si 3 N 4} \times {ε}_{r}^{Si 3 N 4} = 48.75$ greater than ${E}_{crit}^{SixNy} \times {ε}_{r}^{SixNy} < 48.75$ and than ${E}_{crit}^{SiO 2} \times {ε}_{r}^{SiO 2} = 35.1$.

It should be noted that ${E}_{crit}^{SixNy} \times {ε}_{r}^{SixNy}$ is always lower than ${E}_{crit}^{Si 3 N 4} \times {ε}_{r}^{Si 3 N 4}$. Since the proportion of nitrogen (N) compared to silicon (Si) is reduced, the mechanical stress and electrical properties of a non-stoichiometric silicon-rich silicon nitride layer (SiₓN_{y}) is reduced compared to a stoichiometric silicon nitride layer (Si₃N₄).

As we detail below, the inventors' experimental results confirm that the proposed dielectric structure 120 presents an increased dielectric strength and a reduced leakage current.

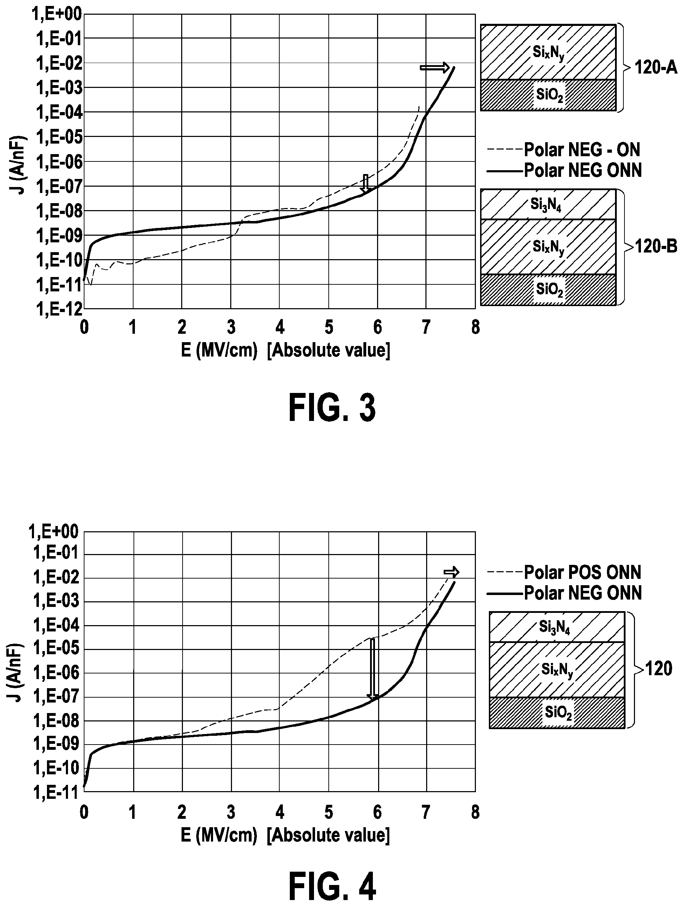

**FIG. 3** illustrates experimental results related to the invention. This figure compares the dielectric performance of a bilayer dielectric structure (dashed line) and a trilayer dielectric structure (solid line).

More precisely, the plot on this figure shows the current density J in the dielectric structure as a function of the electrical field E applied to it (for the bilayer and trilayer dielectric structures).

The bilayer dielectric structure 120-A (dashed line) is formed by a stack of a silicon oxide (SiO₂) layer and a non-stoichiometric silicon-rich silicon nitride (SiₓN_{y}) layer. The trilayer dielectric structure 120-B (solid line) further comprises a stoichiometric silicon nitride (Si₃N₄) layer with a thickness of 50 nm. This Si₃N₄ layer has the highest figure of merit *E*_{crit} × *εᵣ* and is placed between the cathode and the SiₓN_{y} layer.

As shown in FIG. 3, the introduction of a thin layer of silicon nitride in front of the cathode provides the following advantages. First, it reduces the current density within the dielectric structure at high electrical field values (as indicated by the vertical arrow in this figure). Second, it increases the dielectric strength of the dielectric structure by approximatively 10% (as indicated by the horizontal arrow).

The proposed solution thus provides a dielectric structure with higher dielectric strength and reduced leakage current, *i.e.,* with improved dielectric performance. It follows that the capacitor using this dielectric structure presents an increased breakdown voltage and improved reliability.

The advantages of the proposed solution are further corroborated by the experimental results shown in the following figure.

**FIG. 4** illustrates experimental results related to the invention. This figure compares the dielectric performance of a trilayer dielectric structure according to different polarities.

The plot on this figure shows the current density J in the dielectric structure as a function of the electrical field E applied to it (for the different polarities).

The trilayer dielectric structure 120 is formed by a stack of a silicon oxide (SiO₂) layer, a non-stoichiometric silicon-rich silicon nitride (SiₓN_{y}) layer, and a stoichiometric silicon nitride (Si₃N₄) layer. The Si₃N₄ layer presents the highest figure of merit *E*_{crit} × *εᵣ*.

In the first polarity (noted POS and in dashed line on this figure), the Si₃N₄ layer is placed in front of the anode. And, in the second polarity (noted NEG and in solid line on this figure), the Si₃N₄ layer is placed in front of the cathode.

As shown in this FIG. 4, placing the layer with the highest figure of merit *E*_{crit} × *εᵣ* in front of the cathode provides the following advantages. First, it significantly reduces the current density in the dielectric structure (as indicated by the vertical arrow in this figure). The current density is reduced by more than 100 times for electric field values between 5 and 6 MV/m (corresponding to the electrical field values of the envisaged applications). Second, it also increases the dielectric strength of the dielectric structure (as indicated by the horizontal arrow in this figure).

The experimental results in this figure confirm that the cathode is the critical electrode in a polarized capacitor. They also demonstrate that placing the layer with the highest figure of merit *E*_{crit} × *εᵣ* in front of the cathode improves the dielectric performance of the dielectric structure.

**Additional Variants:** Although the present invention has been described above with reference to certain specific embodiments, it will be understood that the invention is not limited by the particularities of these specific embodiments. Numerous variations, modifications, and developments may be made in the above-described embodiments within the scope of the claims.

In particular, the present invention has been described in reference to a capacitor with a 3D capacitive structure and intended for high-voltage applications. However, other embodiments of the present invention could be envisaged, for instance, embodiments in which the capacitor has a planar capacitive structure or is intended for applications other than high voltage applications.

It is to be understood that references in this text to directions and locations, such as *"top"* and *"bottom", "front"* and *"rear",* merely refer to the directions that apply when architectures and components are oriented as illustrated in the accompanying drawings.

### Annexes

**Table 1: properties of various materials that can be used for the dielectric structure considering thin films (thickness between 1 nm and 20 nm, or between 1 nm and 100 m)**

| **Material** | ***εᵣ*** | ***E*_{crit}** | ***E*_{crit} × *εᵣ*** |
|---|---|---|---|
| SiO₂ (Thermal) | 3.9 | 15 | 58.5 |
| Si₃N₄ (LPCVD) | 7.5 | 7 | 52.5 |
| SiₓN_{y} x/y>¾ (LPCVD) | ~7.5 | <7 | <52.5 |
| Al₂O₃ (ALD) | 8.8 | 10 | 88 |
| SiON (LPCVD) | ≥4.6 | 13-15 | ~70 |

**Table 2: properties of various materials that can be used for the dielectric structure considering thick films (thickness greater than 500 nm, or even 1,000 nm)**

| **Material** | ***εᵣ*** | ***E*_{crit}** | ***E*_{crit} × *εᵣ*** |
|---|---|---|---|
| SiO₂ (Thermal) | 3.9 | 9 | 35.1 |
| Si₃N₄ (LPCVD) | 7.5 | 6.5 | 48.75 |
| SiₓN_{y} x/y>¾ (LPCVD) | ~7.5 | <6.5 | <48.75 |
| Al₂O₃ (ALD) | N/A | | |
| SiON (LPCVD) | ≥4.6 | 11 | 50.6 |

## Claims

1. An electrical device (100) comprising a capacitor including: a cathode capacitor electrode (110), an anode capacitor electrode (130), and a dielectric structure (120) interposed between the cathode capacitor electrode (110) and the anode capacitor electrode (130),
wherein the dielectric structure (120) comprises a stack of dielectric layers (121-123) including: a dielectric layer (121) in contact with the cathode capacitor electrode (110), and two or more other dielectric layers (122, 123), and
wherein a product of a dielectric strength ( ${E}_{crit}^{121}$) and a permittivity ( ${ε}_{r}^{121}$) of the dielectric layer (121) in contact with the cathode capacitor electrode (110) is greater than a product of a dielectric strength ( ${E}_{crit}^{122} , {E}_{crit}^{123}$) and a permittivity ( ${ε}_{r}^{122} , {ε}_{r}^{123}$) of each of said two or more other dielectric layers (122, 123), and
wherein:
the dielectric layer (121) in contact with the cathode capacitor electrode (110) comprises stoichiometric silicon nitride and has a thickness comprised between 20 nm and 200 nm,
at least one of said two or more other dielectric layers (122, 123) includes a layer (122) comprising non-stoichiometric silicon-rich silicon nitride and having a thickness comprised between 500nm and 1500nm, and
at least one of said two or more other dielectric layers (122, 123) includes a layer (123) comprising silicon oxide and having a thickness comprised between 100 nm and 1000 nm.

2. The electrical device (100) according to claim 1, wherein an intrinsic mechanical stress of the layer (122) comprising non-stoichiometric silicon-rich silicon nitride is comprised between 300 MPa and 600 MPa.

3. The electrical device (100) according to claim 1 or 2, wherein the cathode capacitor electrode (110) comprises a metal layer, or a degenerate semiconductor layer, or a trap-rich layer.

4. The electrical device (100) according to any of claims 1 to 3, wherein the anode capacitor electrode (130) or the cathode capacitor electrode (110) comprises a conductive structure having reliefs, such as pores, holes, trenches, or pillars.

5. The electrical device (100) according to any of claims 1 to 4, wherein the electrical device (100) is configured to be used with an operating voltage measured between the anode capacitor electrode (130) and the cathode capacitor electrode (110) exceeding 900 V or 1200 V, and preferably with an operating voltage comprised between 1200 V and 1500 V.

6. The electrical device (100) according to any of claims 1 to 4, wherein the electrical device (100) is configured to be used with an operating voltage measured between the anode capacitor electrode (130) and the cathode capacitor electrode (110) comprised between 0.65 V and 10 V.

7. An electronic circuit comprising a voltage supply and an electrical device (100) according to any of claims 1 to 6, wherein the anode capacitor electrode (130) of the electrical device (100) is connected to a positive output of the voltage supply and the cathode capacitor electrode (110) of the electrical device (100) is connected to a negative output of the voltage supply.

8. A method for manufacturing an electrical device (100) comprising a capacitor, said method comprising:
forming a capacitor of the electrical device (100) including: a cathode capacitor electrode (110), an anode capacitor electrode (130), and a dielectric structure (120) interposed between the cathode capacitor electrode (110) and the anode capacitor electrode (130),
wherein the dielectric structure (120) comprises a stack of dielectric layers (121-123) including: a dielectric layer (121) in contact with the cathode capacitor electrode (110), and two or more other dielectric layers (122, 123), and
wherein a product of a dielectric strength ( ${E}_{crit}^{121}$) and a permittivity ( ${ε}_{r}^{121}$) of the dielectric layer (121) in contact with the cathode capacitor electrode (110) is greater than a product of a dielectric strength ( ${E}_{crit}^{122} , {E}_{crit}^{123}$) and a permittivity ( ${ε}_{r}^{122} , {ε}_{r}^{123}$) of each of said two or more other dielectric layers (122, 123) , and
wherein:
**the dielectric** layer (121) in contact with the cathode capacitor electrode (110) comprises stoichiometric silicon nitride and has a thickness comprised between 20 nm and 200 nm,
at least one of said two or more other dielectric layers (122, 123) includes a layer (122) comprising non-stoichiometric silicon-rich silicon nitride and having a thickness comprised between 500nm and 1500nm, and
at least one of said two or more other dielectric layers (122, 123) includes a layer (123) comprising silicon oxide and having a thickness comprised between 100 nm and 1000 nm.

9. The method according to claim 8, comprising a preliminary step of selecting the dielectric layer (121) in contact with the cathode capacitor electrode (110) such that:
the product of the dielectric strength ( ${E}_{crit}^{121}$) and the permittivity ( ${ε}_{r}^{121}$) of the dielectric layer (121) in contact with the cathode capacitor electrode (110) is greater than the product of the dielectric strength ( ${E}_{crit}^{122} , {E}_{crit}^{123}$) and the permittivity ( ${ε}_{r}^{122} , {ε}_{r}^{123}$) of each of said two or more other dielectric layers (122, 123).

10. The method according to claim 9, comprising for each dielectric layer (121-123) of the dielectric structure (120):
obtaining the product of the dielectric strength ( ${E}_{crit}^{121} - {E}_{crit}^{123}$) and the permittivity ( ${ε}_{r}^{121} - {ε}_{r}^{123}$ ) of the dielectric layer (121-123).

11. The method according to claim 10, wherein the product of the dielectric strength ( ${E}_{crit}^{121} - {E}_{crit}^{123}$ ) and the permittivity ( ${ε}_{r}^{121} - {ε}_{r}^{123}$) of each dielectric layer (121-123) is obtained based on:
a property of a material comprised in this dielectric layer (121-123), and
a thickness of this dielectric layer (121-123), and
preferably also on a deposition technique used for this dielectric layer (121-123).

## Patentansprüche

1. Elektrische Vorrichtung (100), umfassend einen Kondensator, der Folgendes beinhaltet: eine Kathodenkondensatorelektrode (110), eine Anodenkondensatorelektrode (130) und eine dielektrische Struktur (120), die zwischen die Kathodenkondensatorelektrode (110) und die Anodenkondensatorelektrode (130) eingefügt ist,
wobei die dielektrische Struktur (120) einen Stapel von dielektrischen Schichten (121-123) umfasst, die Folgendes beinhalten: eine dielektrischen Schicht (121) in Kontakt mit der Kathodenkondensatorelektrode (110) und zwei oder mehrere weitere dielektrische Schichten (122, 123), und
wobei ein Produkt aus einer Durchschlagsfestigkeit ( ${E}_{crit}^{121}$) und einer Permittivität ( ${ε}_{r}^{121}$) der dielektrischen Schicht (121) in Kontakt mit der Kathodenkondensatorelektrode (110) größer ist als ein Produkt aus einer Durchschlagsfestigkeit ( ${E}_{crit}^{122} , {E}_{crit}^{123}$) und einer Permittivität ( ${ε}_{r}^{122} , {ε}_{r}^{123}$) jeder der zwei oder mehreren weiteren dielektrischen Schichten (122, 123), und
wobei:
die dielektrische Schicht (121) in Kontakt mit der Kathodenkondensatorelektrode (110) stöchiometrisches Siliziumnitrid umfasst und eine Stärke zwischen 20 nm und 200 nm aufweist,
mindestens eine der zwei oder mehreren weiteren dielektrischen Schichten (122, 123) eine Schicht (122) beinhaltet, umfassend nicht-stöchiometrisches, siliziumreiches Siliziumnitrid und die eine Stärke zwischen 500 nm und 1500 nm aufweist, und
mindestens eine der zwei oder mehreren weiteren dielektrischen Schichten (122, 123) eine Schicht (123) beinhaltet, umfassend Siliziumoxid und die eine Stärke zwischen 100 nm und 1000 nm aufweist.

2. Elektrische Vorrichtung (100) nach Anspruch 1, wobei eine intrinsische mechanische Spannung der Schicht (122), die nicht-stöchiometrisches, siliziumreiches Siliziumnitrid umfasst, zwischen 300 MPa und 600 MPa liegt.

3. Elektrische Vorrichtung (100) nach Anspruch 1 oder 2, wobei die Kathodenkondensatorelektrode (110) eine Metallschicht oder eine degenerierte Halbleiterschicht oder eine Trap-Rich-Schicht umfasst.

4. Elektrische Vorrichtung (100) nach einem der Ansprüche 1 bis 3, wobei die Anodenkondensatorelektrode (130) oder die Kathodenkondensatorelektrode (110) eine leitende Struktur umfasst, die Reliefs aufweist, wie beispielsweise Poren, Löcher, Gräben oder Säulen.

5. Elektrische Vorrichtung (100) nach einem der Ansprüche 1 bis 4, wobei die elektrische Vorrichtung (100) konfiguriert ist, um mit einer zwischen der Anodenkondensatorelektrode (130) und der Kathodenkondensatorelektrode (110) gemessenen Betriebsspannung, die 900 V oder 1200 V überschreitet, und vorzugsweise mit einer Betriebsspannung zwischen 1200 V und 1500 V verwendet zu werden.

6. Elektrische Vorrichtung (100) nach einem der Ansprüche 1 bis 4, wobei die elektrische Vorrichtung (100) konfiguriert ist, um mit einer zwischen der Anodenkondensatorelektrode (130) und der Kathodenkondensatorelektrode (110) gemessenen Betriebsspannung zwischen 0,65 V und 10 V verwendet zu werden.

7. Elektronische Schaltung, umfassend eine Spannungsversorgung und eine elektrische Vorrichtung (100) nach einem der Ansprüche 1 bis 6, wobei die Anodenkondensatorelektrode (130) der elektrischen Vorrichtung (100) mit einem positiven Ausgang der Spannungsversorgung verbunden ist und die Kathodenkondensatorelektrode (110) der elektrischen Vorrichtung (100) mit einem negativen Ausgang der Spannungsversorgung verbunden ist.

8. Verfahren zum Herstellen einer elektrischen Vorrichtung (100), umfassend einen Kondensator, das Verfahren umfassend:
Bilden eines Kondensators der elektrischen Vorrichtung (100), die Folgendes beinhaltet: eine Kathodenkondensatorelektrode (110), eine Anodenkondensatorelektrode (130) und eine dielektrische Struktur (120), die zwischen die Kathodenkondensatorelektrode (110) und die Anodenkondensatorelektrode (130) eingefügt ist,
wobei die dielektrische Struktur (120) einen Stapel von dielektrischen Schichten (121-123) umfasst, die Folgendes beinhalten: eine dielektrische Schicht (121) in Kontakt mit der Kathodenkondensatorelektrode (110) und zwei oder mehrere weitere dielektrische Schichten (122, 123), und
wobei ein Produkt aus einer Durchschlagsfestigkeit ( ${E}_{crit}^{121}$) und einer Permittivität ( ${ε}_{r}^{121}$) der dielektrischen Schicht (121) in Kontakt mit der Kathodenkondensatorelektrode (110) größer ist als ein Produkt aus einer Durchschlagsfestigkeit ( ${E}_{crit}^{122} , {E}_{crit}^{123}$) und einer Permittivität ( ${ε}_{r}^{122} , {ε}_{r}^{123}$) jeder der zwei oder mehreren weiteren dielektrischen Schichten (122, 123), und
wobei:
die dielektrische Schicht (121) in Kontakt mit der Kathodenkondensatorelektrode (110) stöchiometrisches Siliziumnitrid umfasst und eine Stärke aufweist, die zwischen 20 nm und 200 nm liegt,
mindestens eine der zwei oder mehreren weiteren dielektrischen Schichten (122, 123) eine Schicht (122) beinhaltet, umfassend nicht-stöchiometrisches, siliziumreiches Siliziumnitrid und die eine Stärke aufweist, die zwischen 500 nm und 1500 nm liegt, und
mindestens eine der zwei oder mehreren weiteren dielektrischen Schichten (122, 123) eine Schicht (123) beinhaltet, umfassend Siliziumoxid und die eine Stärke zwischen 100 nm und 1000 nm aufweist.

9. Verfahren nach Anspruch 8, umfassend einen vorausgehenden Schritt eines Auswählens der dielektrischen Schicht (121) in Kontakt mit der Kathodenkondensatorelektrode (110) sodass:
das Produkt aus der Durchschlagsfestigkeit ( ${E}_{crit}^{121}$) und der Permittivität ( ${ε}_{r}^{121}$) der dielektrischen Schicht (121) in Kontakt mit der Kathodenkondensatorelektrode (110) größer ist als das Produkt aus der Durchschlagsfestigkeit ( ${E}_{crit}^{122} , {E}_{crit}^{123}$) und der Permittivität ( ${ε}_{r}^{122} , {ε}_{r}^{123}$) jeder der zwei oder mehreren weiteren dielektrischen Schichten (122, 123).

10. Verfahren nach Anspruch 9, umfassend für jede dielektrische Schicht (121-123) der dielektrischen Struktur (120):
Erlangen des Produkts aus der Durchschlagsfestigkeit ( ${E}_{crit}^{121} - {E}_{crit}^{123}$) und der Permittivität ( ${ε}_{r}^{121} - {ε}_{r}^{123}$) der dielektrischen Schicht (121-123).

11. Verfahren nach Anspruch 10, wobei das Produkt aus der Durchschlagsfestigkeit ( ${E}_{crit}^{121} - {E}_{crit}^{123}$) und der Permittivität ( ${ε}_{r}^{121} - {ε}_{r}^{123}$) jeder dielektrischen Schicht (121-123) basierend auf Folgendem erlangt wird:
einer Eigenschaft eines in dieser dielektrischen Schicht (121-123) enthaltenen Materials, und
einer Stärke dieser dielektrischen Schicht (121-123), und
vorzugsweise auch auf einer Abscheidungstechnik, die für diese dielektrische Schicht (121-123) verwendet wird.

## Revendications

1. **Dispositif** électrique (100) comprenant un condensateur incluant : une électrode de condensateur cathodique (110), une électrode de condensateur anodique (130), et une structure diélectrique (120) interposée entre l'électrode de condensateur cathodique (110) et l'électrode de condensateur anodique (130),
dans lequel la structure diélectrique (120) comprend un empilement de couches diélectriques (121-123) comprenant : une couche diélectrique (121) en contact avec l'électrode de condensateur cathodique (110), et deux autres couches diélectriques ou plus (122, 123), et
dans lequel un produit d'une rigidité diélectrique ( ${E}_{crit}^{121}$) et d'une permittivité ( ${ε}_{r}^{121}$) de la couche diélectrique (121) en contact avec l'électrode de condensateur cathodique (110) est supérieur à un produit d'une rigidité diélectrique ( ${E}_{crit}^{122} , {E}_{crit}^{123}$) et d'une permittivité ( ${ε}_{r}^{122} , {ε}_{r}^{123}$) de chacune desdites deux autres couches diélectriques ou plus (122, 123), et
dans lequel :
la couche diélectrique (121) en contact avec l'électrode de condensateur cathodique (110) comprend du nitrure de silicium stœchiométrique et présente une épaisseur comprise entre 20 nm et 200 nm,
au moins une desdites deux autres couches diélectriques ou plus (122, 123) comprend une couche (122) comprenant du nitrure de silicium enrichi en silicium non stœchiométrique et présentant une épaisseur comprise entre 500 nm et 1500 nm, et
au moins une desdites deux autres couches diélectriques ou plus (122, 123) comprend une couche (123) comprenant de l'oxyde de silicium et présentant une épaisseur comprise entre 100 nm et 1000 nm.

2. Dispositif électrique (100) selon la revendication 1, dans lequel une contrainte mécanique intrinsèque de la couche (122) comprenant du nitrure de silicium enrichi en silicium non stœchiométrique est comprise entre 300 MPa et 600 MPa.

3. Dispositif électrique (100) selon la revendication 1 ou 2, dans lequel l'électrode de condensateur cathodique (110) comprend une couche métallique, ou une couche de semi-conducteur dégénéré, ou une couche riche en pièges.

4. Dispositif électrique (100) selon l'une quelconque des revendications 1 à 3, dans lequel l'électrode de condensateur anodique (130) ou l'électrode de condensateur cathodique (110) comprend une structure conductrice présentant des reliefs, tels que des pores, des trous, des tranchées ou des plots.

5. Dispositif électrique (100) selon l'une quelconque des revendications 1 à 4, dans lequel le dispositif électrique (100) est configuré pour être utilisé avec une tension de fonctionnement mesurée entre l'électrode de condensateur anodique (130) et l'électrode de condensateur cathodique (110) supérieure à 900 V ou 1200 V, et de préférence avec une tension de fonctionnement comprise entre 1200 V et 1500 V.

6. Dispositif électrique (100) selon l'une quelconque des revendications 1 à 4, dans lequel le dispositif électrique (100) est configuré pour être utilisé avec une tension de fonctionnement mesurée entre l'électrode de condensateur anodique (130) et l'électrode de condensateur cathodique (110) comprise entre 0,65 V et 10 V.

7. **Circuit** électronique comprenant une alimentation en tension et un dispositif électrique (100) selon l'une quelconque des revendications 1 à 6, dans lequel l'électrode de condensateur anodique (130) du dispositif électrique (100) est connectée à une sortie positive de l'alimentation en tension et l'électrode de condensateur cathodique (110) du dispositif électrique (100) est connectée à une sortie négative de l'alimentation en tension.

8. Procédé de fabrication d'un dispositif électrique (100) comprenant un condensateur, ledit procédé comprenant :
la formation d'un condensateur du dispositif électrique (100) comprenant : une électrode de condensateur cathodique (110), une électrode de condensateur anodique (130), et une structure diélectrique (120) interposée entre l'électrode de condensateur cathodique (110) et l'électrode de condensateur anodique (130),
dans lequel la structure diélectrique (120) comprend un empilement de couches diélectriques (121-123) comprenant : une couche diélectrique (121) en contact avec l'électrode de condensateur cathodique (110), et deux autres couches diélectriques ou plus (122, 123), et
dans lequel un produit d'une rigidité diélectrique ( ${E}_{crit}^{121}$) et d'une permittivité ( ${ε}_{r}^{121}$) de la couche diélectrique (121) en contact avec l'électrode de condensateur cathodique (110) est supérieur à un produit d'une rigidité diélectrique ( ${E}_{crit}^{122} , {E}_{crit}^{123}$) et d'une permittivité ( ${ε}_{r}^{122} , {ε}_{r}^{123}$ ) de chacune desdites deux autres couches diélectriques ou plus (122, 123), et
dans lequel :
la couche diélectrique (121) en contact avec l'électrode de condensateur cathodique (110) comprend du nitrure de silicium stœchiométrique et présente une épaisseur comprise entre 20 nm et 200 nm,
au moins une desdites deux autres couches diélectriques ou plus (122, 123) comprend une couche (122) comprenant du nitrure de silicium enrichi en silicium non stœchiométrique et présentant une épaisseur comprise entre 500 nm et 1500 nm, et
au moins une desdites deux autres couches diélectriques ou plus (122, 123) comprend une couche (123) comprenant de l'oxyde de silicium et présentant une épaisseur comprise entre 100 nm et 1000 nm.

9. Procédé selon la revendication 8, comprenant une étape préliminaire de sélection de la couche diélectrique (121) en contact avec l'électrode de condensateur cathodique (110) de sorte que :
le produit de la rigidité diélectrique ( ${E}_{crit}^{121}$) et de la permittivité ( ${ε}_{r}^{121}$) de la couche diélectrique (121) en contact avec l'électrode de condensateur cathodique (110) est supérieur au produit de la rigidité diélectrique ( ${E}_{crit}^{122} , {E}_{crit}^{123}$) et de la permittivité ( ${ε}_{r}^{122} , {ε}_{r}^{123}$) de chacune desdites deux autres couches diélectriques ou plus (122, 123).

10. Procédé selon la revendication 9, comprenant, pour chaque couche diélectrique (121-123) de la structure diélectrique (120) :
l'obtention du produit de la rigidité diélectrique ( ${E}_{crit}^{121} - {E}_{crit}^{123}$) et de la permittivité ( ${ε}_{r}^{121} - {ε}_{r}^{123}$) de la couche diélectrique (121-123).

11. Procédé selon la revendication 10, dans lequel le produit de la rigidité diélectrique ( ${E}_{crit}^{121} - {E}_{crit}^{123}$) et de la permittivité ( ${ε}_{r}^{121} - {ε}_{r}^{123}$) de chaque couche diélectrique (121-123) est obtenu sur la base :
d'une propriété d'un matériau compris dans cette couche diélectrique (121-123), et
d'une épaisseur de cette couche diélectrique (121-123), et
de préférence également sur la base d'une technique de dépôt utilisée pour cette couche diélectrique (121-123).
